# EUROPEAN PATENT APPLICATION

(11) **EP 1 167 416 A1**
(43) Date of publication of application: **02.01.2002**
(21) Application number: 01901509.8
(22) Date of filing: 23.01.2001
(51) Int. Cl.: C08G 18/73, C08G 18/75, H01L 33/00, H01L 31/02, H01L 23/29

(54) **URETHANE RESIN COMPOSITION FOR SEALING OPTOELECTRIC CONVERSION DEVICES**

(30) Priority: 24.01.2000 JP 2000013786
(71) Applicant: Mitsui Chemicals, Inc., Tokyo 100-6070 (JP)
(72) Inventor: KAWANABE, Hisashi, Mitsui Chemicals, Inc., Sodegaura-shi, Chiba 299-0265 (JP); MEGA, Izumi, Mitsui Chemicals, Inc., Sodegaura-shi, Chiba 299-0265 (JP); YAMASAKI, Satoshi, Mitsui Chemicals, Inc., Sodegaura-shi, Chiba 299-0265 (JP); YAMADA, Kunihiro, Mitsui Chemicals, Inc., Omuta-shi, Fukuoka 836-0817 (JP); ITOU, Hisato, Mitsui Chemicals, Inc., Sakae-ku, Yokohama-shi,Kanagawa 247-0006 (JP); TORISU, Masaaki, Mitsui Chemicals, Inc., Omuta-shi, Fukuoka 836-0817 (JP)
(74) Representative: Stuart, Ian Alexander
(86) International application number: JP0100406
(87) International publication number: WO0153374

(57) **Abstract**

A urethane resin composition for an optoelectric conversion element sealer according to the present invention is a urethane resin composition for an optoelectric conversion element sealer comprising a component (A) containing a compound having isocyanate groups and a component (B) containing a compound having hydroxyl groups, wherein the compound having isocyanate groups is at least one compound selected from the group consisting of an aromatic isocyanate having a structure in which the isocyanate groups are not directly bonded to a benzene ring, an aliphatic isocyanate, an alicyclic isocyanate, and derivatives of these isocyanates.

## Description

### Technical Field

The present invention relates to a urethane resin for an optoelectric conversion element sealer, a urethane resin composition, use applications and production methods thereof. More specifically, it relates to a urethane resin for an optoelectric conversion element sealer which has excellent weather resistance and is hardly discolored, a urethane resin composition for an optoelectric conversion element sealer which has. good workability, an optoelectric conversion device and a light-emitting or a light-receiving device in which the urethane resin is used as a sealer, use applications of the devices and production methods thereof, and a light-emitting diode lamp and a production method thereof.

### Background Art

Heretofore, to shield an optical semiconductor such as a diode, transistor or IC from outside air, hermetic seal by using a metal, ceramic, glass or the like, or resin seal by using a resin has been carried out. Of these, the hermetic seal is excellent in reliability, but it also has a problem that its production cost is high. Therefore, the resin seal, which can be accomplished at a low cost, is widely spread. As sealers for the resin seal, an epoxy resin, a silicone resin, a polyester resin and the like have been used.

In particular, the sealer for a light-emitting element such as a light-emitting diode (LED) must have such properties as (a) moisture resistance, (b) insulation properties, (c) heat resistance, (d) moldability and workability, (e) mechanical strength, (f) purity, (g) chemical resistance and (h) light transmittance. Heretofore, as the sealer for a light-emitting element such as an LED, an epoxy resin composition has been mainly used, and the sealer can be prepared relatively easily by transfer molding or the like of an epoxy resin composition containing an epoxy resin, a curing agent, an accelerator and a mold releasing agent. Illustrative examples of such an epoxy resin composition include epoxy resins such as a bisphenol A-type, bisphenol F-type and bisphenol S-type, novolac-type epoxy resins such as ortho-cresol and phenol, and alicyclic epoxy resins. Illustrative examples of the curing agent include acid anhydrides such as hexahydrophthalic anhydride, methylhexahydrophthalic anhydride and tetrahydrophthalic anhydride, novolac-type resins obtained by subjecting each of phenol, cresol, xylenol, resorcin and the like and formaldehyde to condensation reaction. Furthermore, there is known an epoxy resin composition for sealing a semiconductor device which contains an amine-based curing agent and the like.

On the other hand, there is known a reactive sealer for the LED in which an isocyanate compound and an active hydrogen compound are used. For example, a light-emitting or a light-receiving device is known, which is sealed by a liquid polymer containing at least one compound selected from the group consisting of aromatic thiol compounds and aliphatic thiol compounds and a polyisocyanate compound. Furthermore, a light-emitting or a light-receiving device is also known, which is sealed by a liquid polymer containing a polyfunctional isocyanate compound and an isocyanurate compound having a mercapto group. In addition, a semiconductor light-emitting device is also known in which at least the light-extracting surface of a light-emitting element is coated with a resin having a high refractive index which is obtained by reacting 1,3-di(isocyanatemethyl)benzene with 4-mercaptomethyl-3,6-dithia-1,8-octanedithiol, and the resin is then covered with a sealing resin.

Of these, however, the silicone resin has poor adhesive strength to a substrate and is liable to remain sticky. The polyester resin has the problems that it shrinks largely after curing and that it is poor in hydrolysis resistance. Meanwhile, the epoxy resin which is generally used as a sealer for the light-emitting element of the LED has a problem that it is poor in productivity since the resin is heated for a long time period of about 10 to 20 hours to be cured, and another problem that when the curing time is shortened, the temperature rapidly increases by heat of the reaction, whereby the reaction becomes uncontrollable. Moreover, shrinkage due to the curing after the reaction is large and occurs quickly, so that the cured resin may have cracks. In addition, the epoxy resin also has a problem that it is liable to be colored by heat or light, thereby lowering light transmittance, with the result that the performance of the LED deteriorates, and another problem that it does not cure on the surface of a surface-mountable LED in sealing the surface-mountable LED.

Furthermore, as a resin composition using a urethane (meth)acrylate, a resin composition containing a urethane (meth)acrylate is known which is obtained by first producing a fluorine-containing (meth)acrylate and then reacting the fluorine-containing (meth)acrylate with a polyol and an organic polyisocyanate. This composition is prepared by the two steps of the reactions, and hence, it is industrially disadvantageous as the sealer for the LED. In addition, the refractive index of the obtained resin is liable to be relatively low.

Furthermore, a urethane sealer obtained from an isocyanate compound and an active hydrogen compound containing sulfur in its molecule provides a high refractive index and transparency. However, since it contains sulfur, it is poor in weathering stability, and when incorporated into an LED, silver parts used in an LED lamp are liable to be sulfurated and blackened when a voltage is applied to the LED.

### Disclosure of Invention

The present invention has been invented to solve the above problems associated with the prior art. It is an object of the present invention to provide a urethane resin and a urethane resin composition for an optoelectric conversion element sealer which have a useful rigidity, refractive index and weathering stability as a sealer for an optoelectric conversion element such as a light-emitting diode, an optoelectric conversion device, a light-emitting or a light-receiving element, a light-emitting diode (LED) lamp, and production methods thereof.

That is, the present invention is characterized by the following (1) to (24).
<1> A urethane resin for an optoelectric conversion element sealer, which has:
   1) a refractive index of 1.45 or more as measured by using a D line from a helium light source,
   2) a glass transition temperature (Tg) of 75°C or more, and
   3) a ΔE of 1.5 or less as measured after irradiation for 600 hours by a sunshine weatherometer using a carbon arc lamp.
<2> The resin described in <1>, which has a ΔE of 1.5 or less after treated for 300 hours in a thermostatic chamber having a relative humidity of 90% and a temperature of 80°C.
<3> The resin described in <1> or <2>, wherein the content of sulfur atoms is 500 ppm or less.
<4> The resin described in any one of <1> to <3>, wherein the content of alkali metal atoms is 10 ppm or less.
<5> A urethane resin composition for an optoelectric conversion element sealer comprising a component (A) containing a compound having at least two isocyanate groups and a component (B) containing a compound having hydroxyl groups, wherein the compound having isocyanate groups in the component (A) is at least one compound selected from the group consisting of:
   (i) an aromatic polyisocyanate having a structure in which any isocyanate groups are not directly bonded to a benzene ring,
   (ii) an aliphatic polyisocyanate,
   (iii) an alicyclic polyisocyanate, and
   (iv) derivatives of the polyisocyanates (i) to (iii).
<6> The composition described in <5>, wherein the compound having isocyanate groups is a modified isocyanurate or prepolymer of the polyisocyanates (i) to (iii).
<7> The composition described in <5> or <6>, wherein an initial mixing viscosity at the time of mixing the component (A) and the component (B) together at 20°C is in a range of 10 to 10,000 mPa·s.
<8> The composition described in any one of <5> to <7>, wherein a time required for a viscosity after mixing of the component (A) and the component (B) to become twice as much as the initial mixing viscosity is in a range of 2 to 20 hours.
<9> The composition described in any one of <5> to <8>, wherein the compound having isocyanate groups is a polycyclic alicyclic polyisocyanate or its modification.
<10> The composition described in <9>, wherein the polycyclic alicyclic polyisocyanate is a polycyclic alicyclic diisocyanate represented by the following general formula [I]: 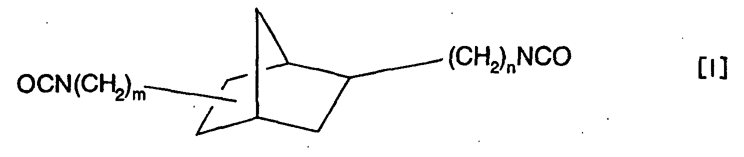 wherein m and n each independently represent an integer of 1 to 5.
<11> The composition described in <10>, wherein the polycyclic alicyclic polyisocyanate is a polycyclic alicyclic diisocyanate represented by the formula [I] wherein both m and n are 1.
<12> The composition described in <5>, wherein the compound having isocyanate groups is at least one compound selected from the group consisting of diisocyanatomethylbenzene, bis(1-isocyanato-1,1-dimethyl)benzene, 4,4'-diisocyanato-dicyclohexylmethane, 1-isocyanato-3,5,5-trimethyl-3-isocyanatomethylcyclohexane and bisisocyanatomethylcyclohexane.
<13> The composition described in any one of <5> to <12>, wherein the compound having hydroxyl groups is a compound having at least two hydroxyl groups.
<14> The composition described in <12> or <13>, wherein the content of alkali metal atoms in the compound having at least two hydroxyl groups is 10 ppm or less.
<15> The composition described in any one of <5> to <14>, which has a glass transition temperature of at least 75°C after cured.
<16> The composition described in any one of <5> to <15>, which has a refractive index of 1.45 to 1.80 as measured by using a D line from a helium light source after cured.
<17> The composition described in <5> or <16>, which has
   a ΔE of 1.5 or less as measured after irradiation for 600 hours by a sunshine weatherometer using a carbon arc lamp after cured,
   a ΔE of 1.5 or less after treated for 300 hours in a thermostatic chamber having a relative humidity of 90% and a temperature of 80°C,
   a content of sulfur atoms of 500 ppm or less, and
   a content of alkali metal atoms of 10 ppm or less.
<18> An optoelectric conversion device obtained by curing a resin composition comprising a component (A) containing a compound having isocyanate groups and a component (B) containing a compound having hydroxyl groups to seal an optoelectric conversion element, wherein the compound having isocyanate groups in the component (A) is at least one compound selected from the group consisting of:
   (i) an aromatic polyisocyanate having a structure in which any isocyanate groups are not directly bonded to a benzene ring,
   (ii) an aliphatic polyisocyanate,
   (iii) an alicyclic polyisocyanate, and
   (iv) derivatives of the polyisocyanates (i) to (iii).
<19> The device described in <18>, wherein the optoelectric conversion element is a light-emitting or a light-receiving element.
<20> The device described in <19>, wherein the optoelectric conversion element is a light-emitting diode.
<21> A method for producing a urethane resin for an optoelectric conversion element sealer which comprises heating a resin composition comprising a component (A) containing a compound having isocyanate groups and a component (B) containing a compound having hydroxyl groups to react and cure the composition, wherein the compound having isocyanate groups in the component (A) is at least one compound selected from the group consisting of:
   (i) an aromatic polyisocyanate having a structure in which any isocyanate groups are not directly bonded to a benzene ring,
   (ii) an aliphatic polyisocyanate,
   (iii) an alicyclic polyisocyanate, and
   (iv) derivatives of the polyisocyanates (i) to (iii).
<22> A method for producing an optoelectric conversion device which comprises sealing an optoelectric conversion element with a resin composition comprising a component (A) containing a compound having isocyanate groups and a component (B) containing a compound having hydroxyl groups by heating the resin composition to react and cure the composition, wherein the compound having isocyanate groups in the component (A) is at least one compound selected from the group consisting of:
   (i) an aromatic polyisocyanate having a structure in which any isocyanate groups are not directly bonded to a benzene ring,
   (ii) an aliphatic polyisocyanate,
   (iii) an alicyclic polyisocyanate, and
   (iv) derivatives of the polyisocyanates (i) to (iii).
<23> The method described in <22>, wherein the optoelectric conversion element is a light-emitting or a light-receiving element.
<24> The method described in <23>, wherein the optoelectric conversion element is a light-emitting diode.

### Best Mode for Carrying Out the Invention

The present invention relates to a urethane resin and a urethane resin composition which are suitable for an optoelectric conversion element sealer; an optoelectric conversion device sealed by the urethane resin, and their production methods.

### [Urethane resin for optoelectric conversion element sealer]

The urethane resin for an optoelectric conversion element sealer of the present invention has:
1) a refractive index of 1.45 or more as measured by using a D line from a helium light source,
2) a glass transition temperature (Tg) of 75°C or more, and
3) a ΔE of 1.5 or less as measured after irradiation for 600 hours by a sunshine weatherometer using a carbon arc lamp.
   Preferably, this urethane resin for an optoelectric conversion element sealer has:
4) a ΔE of 1.5 or less after treated for 300 hours in a thermostatic chamber having a relative humidity of 90% and a temperature of 80°C.
   More preferably, this urethane resin for an optoelectric conversion element sealer has:
5) a content of sulfur atoms of 500 ppm or less.

Particularly preferably, this urethane resin for an optoelectric conversion element sealer contains alkali metal atoms in an amount of 10 ppm or less.

The urethane resin composition'for an optoelectric conversion element sealer of the present invention comprises a component (A) containing a compound having at least two isocyanate groups and a component (B) containing a compound having hydroxyl groups, wherein the compound having isocyanate groups in the component (A) is at least one compound selected from the group consisting of:
(i) an aromatic polyisocyanate having a structure in which any isocyanate groups are not directly bonded to a benzene ring,
(ii) an aliphatic polyisocyanate,
(iii) an alicyclic polyisocyanate, and
(iv) derivatives of the polyisocyanates (i) to (iii).

The above compound having isocyanate groups is preferably a modified isocyanurate or prepolymer of the polyisocyanates (i) to (iii).

Further, the initial mixing viscosity at the time of mixing the above component (A) and the above component (B) together at 20°C is preferably 10 to 10,000 mPa·s.

A time required for a viscosity after mixing of the above component (A) and the above component (B) to become twice as much as the initial mixing viscosity is preferably in a range of 2 to 20 hours.

The above compound having isocyanate groups is preferably a polycyclic alicyclic polyisocyanate or its modification.

The above polycyclic alicyclic polyisocyanate is more preferably a polycyclic alicyclic diisocyanate represented by the following general formula [I]: 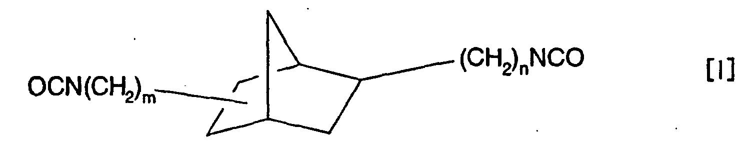 wherein m and n each independently represent an integer of 1 to 5.

The above polycyclic alicyclic polyisocyanate is particularly preferably a polycyclic alicyclic diisocyanate represented by the above formula [I] wherein both m and n are 1.

The above compound having isocyanate groups is most preferably at least one compound selected from the group consisting of diisocyanatemethylbenzene, bis(1-isocyanato-1,1,-dimethyl)benzene, 4,4'-diisocyanato-dicyclohexylmethane, 1-isocyanato-3,5,5-trimethyl-3-isocyanatomethylcyclohexane and bisisocyanatomethylcyclohexane.

The above compound having hydroxyl groups is preferably a compound having at least two hydroxyl groups.

The content of alkali metal atoms in the above compound having at least two hydroxyl groups is more preferably 10 ppm or less.

The optoelectric conversion device of the present invention is an optoelectric conversion device obtained by sealing an optoelectric conversion element by curing a composition comprising a component (A) containing a compound having isocyanate groups and a component (B) containing a compound having hydroxyl groups, wherein the above compound having isocyanate groups in the component (A) is at least one compound selected from the group consisting of:
(i) an aromatic polyisocyanate having a structure in which any isocyanate groups are not directly bonded to the benzene ring,
(ii) an aliphatic polyisocyanate,
(iii) an alicyclic polyisocyanate, and
(iv) derivatives of the polyisocyanates (i) to (iii).

The optoelectric conversion element is preferably a light-emitting or a light-receiving element.

The optoelectric conversion element is preferably a light-emitting diode.

As described above, the urethane resin composition for an optoelectric conversion element sealer which is used in the present invention comprises the component (A) containing a compound having at least two isocyanate groups and the component (B) containing hydroxyl groups and is obtained by mixing the component (A) and the component (B) together. In general, the component (B) contains a polyol, and the component (A) and the component (B) may contain other additives as required.

A detailed description will be given to the urethane resin composition for an optoelectric conversion element sealer, a light-emitting or a light-receiving element, a light-emitting diode (LED) lamp, and production methods thereof hereinafter.

### [Urethane resin composition for optoelectric conversion element sealer]

The urethane resin composition for an optoelectric conversion element sealer according to the present invention comprises a component (A) containing a compound having isocyanate groups and a component (B) containing a compound having hydroxyl groups.

As for the mixing ratio of the component (A) containing a compound having isocyanate groups and the component (B) containing a compound having hydroxyl groups, they are mixed together such that the molar ratio (NCO/OH ratio) of the isocyanate groups in the component (A) and the hydroxyl groups in the component (B) should be generally 0.5 to 2.5, preferably 0.6 to 1.8, more preferably 0.8 to 1.3.

The urethane resin obtained by curing the urethane resin composition for an optoelectric conversion element sealer according to the present invention desirably has a glass transition temperature of preferably at least 75°C, more preferably at least 85°C, most preferably at least 90°C. When a light-emitting diode (LED) is sealed by the urethane resin, a higher glass transition temperature is more preferable. When the art of the present invention is applied, the upper limit of the glass transition temperature is about 200°C. When the glass transition temperature is at least 75°C, the heat resistance and weather resistance as well as elastic modulus of the urethane resin for an optoelectric conversion element sealer improve, and the durability of the produced light-emitting diode (LED) lamp also improves advantageously.

Further, the urethane resin for an optoelectric conversion element sealer according to the present invention desirably has a refractive index of preferably 1.45 to 1.80, more preferably 1.46 to 1.75, most preferably 1.48 to 1.70 as measured by using a D line (587.6 nm) from a helium light source. When the refractive index is 1.45 to 1.80, the balance between light-extracting efficiency and the wavelength dependence of the refractive index is excellent advantageously.

Furthermore, the urethane resin for an optoelectric conversion element sealer according to the present invention has a ΔE of preferably 1.5 or less, more preferably 1.2 or less, particularly preferably 1.0 or less as measured after irradiation for 600 hours by a sunshine weatherometer using a carbon arc lamp. When the ΔE is larger than 1.5, the color difference becomes visually perceptible, and the transparency of the urethane resin for an optoelectric conversion element sealer is impaired disadvantageously. When the ΔE is 1.5 or less, the color difference is either imperceptible or extremely small advantageously.

The urethane resin for an optoelectric conversion element sealer according to the present invention has a ΔE of preferably 1.5 or less, more preferably 1.2 or less, particularly preferably 1.0 or less, after treated for 300 hours in a thermostatic chamber having a relative humidity of 90% and a temperature of 80°C. Further, the urethane resin for an optoelectric conversion element sealer according to the present invention desirably has a ΔE of preferably 1.5 or less, more preferably 1.2 or less, most preferably 1.0 or less, after 600 hours at 90°C and 80%RH. When the ΔE is larger than 1.5, the color difference becomes visually perceptible, and the transparency of the urethane resin for an optoelectric conversion element sealer is impaired disadvantageously. When the ΔE is 1.5 or less, the color difference is either imperceptible or extremely small advantageously.

The content of sulfur atoms in the composition is preferably 500 ppm or less, more preferably 300 ppm or less, particularly preferably 100 ppm or less. When the content of the sulfur atoms is higher than 500 ppm, there occurs the inconvenience that the sealer composition is seriously yellowed or browned by irradiation of sunlight, ultraviolet radiation or the like. Further, the sulfur atoms may react with metal components such as silver.

The content of alkali metal atoms in the composition is preferably 10 ppm or less, more preferably 5 ppm or less, particularly preferably 3 ppm or less. When the content of the alkali metal component is higher than 10 ppm, the leakage of electricity by ions is liable to occur at the time of passing a current, and electric characteristics are liable to deteriorate. When the content of the alkali metal component is 10 ppm or less, the reactivity at the time of mixing the components (A) and (B) by stirring is stabilized, and not only the weathering stability of the resin but also the weathering stability and electric characteristics thereof when used to seal an LED to form a lamp improve advantageously.

### <Component (A)>

The isocyanate group-containing compound contained in the component (A) used in the present invention is an organic compound having isocyanate groups and is exemplified by:
(i) an aromatic isocyanate having a structure in which the isocyanate groups are not directly bonded to the benzene ring,
(ii) an aliphatic isocyanate,
(iii) an alicyclic isocyanate, and
(iv) mixed isocyanates and polyisocyanate derivatives thereof such as an isocyanurate, carbodiimide, uretonimine, uretdione, allophanate and biuret and an isocyanate group-terminated urethane prepolymer.

Of these, an aromatic polyisocyanate compound having a structure in which the isocyanate groups are not directly bonded to the benzene ring, an aliphatic polyisocyanate compound and an alicyclic polyisocyanate compound, all of which have at least two isocyanate groups in the molecule; polyisocyanate derivatives thereof such as an isocyanurate, carbodiimide, uretonimine, uretdione, allophanate and biuret; and an isocyanate group-terminated urethane prepolymer obtained by reacting a polyisocyanate having at least two terminal isocyanate groups in the molecule with a compound having hydroxyl groups under stoichiometrically excess conditions are preferable. Particularly, the uses of the above polyisocyanate derivatives and the isocyanate group-terminate urethane prepolymer are preferable from the viewpoint of improving the heat resistance of the urethane resin for an optoelectric conversion element sealer.

### (Compound (isocyanate) having isocyanate groups)

As the isocyanate group-containing compound used in the component (A), an aromatic isocyanate having a structure in which the isocyanate groups are not directly bonded to the benzene ring, an aliphatic isocyanate and an alicyclic isocyanate can be used. Preferably, a polyisocyanate having at least two terminal isocyanate groups in the molecule is used.

By using the aromatic isocyanate having a structure in which the isocyanate groups are not directly bonded to the benzene ring, aliphatic isocyanate and alicyclic isocyanate, mixed isocyanates and isocyanate derivatives thereof such as an isocyanurate, carbodiimide, uretonimine, uretdione, allophanate and biuret, and isocyanate group-terminated urethane prepolymer of the present invention, pot life and workability can be secured and weathering stability can also be imparted.

When an aromatic isocyanate having a structure in which the isocyanate groups are directly bonded to the benzene ring is used as the compound having isocyanate groups, it reacts with a polyol quickly, thereby causing the problem that a desired pot life cannot be secured. Further, although there is also the inconvenience that the sealer composition is seriously yellowed by irradiation of sunlight, ultraviolet radiation or the like, the aromatic isocyanate having a structure in which the isocyanate groups are directly bonded to the aromatic ring may be used in combination with the above compounds, as the isocyanate group-containing component (A) in the urethane resin composition for sealing an optoelectric conversion element according to the present invention.

Illustrative examples of the isocyanate group-containing compound (i) having a structure in which the isocyanate groups are not directly bonded to the benzene ring include 1,3-di(isocyanatomethyl)benzene (m-XDI), 1,4-di(isocyanatomethyl)benzene (p-XDI), 1,3-bis(1-isocyanato-1,1-dimethyl)benzene (m-TMXDI), 1,4-bis(1-isocyanato-1,1-dimethyl)benzene (p-TMXDI), 1-isocyanatomethyl-3-(1-isocyanato-1,1-dimethyl)benzene, 1-isocyanatomethyl-4-(1-isocyanato-1,1-dimethyl)benzene and 1,4-di(isocyanatoethyl)benzene.

Illustrative examples of the aliphatic isocyanate (ii) include 1,5 -diisocyanatopentane, 1,6-diisocyanatohexane (HDI), 1,4-diisocyanatopentane, 1,6-diisocyanato-3,5,5-trimethylhexane, 1,6-diisocyanato-3,3,5-trimethylhexane, 1,12-diisocyanatododecane, 1,8-diisocyanato-4-isocyanatomethyloctane, 1,3,6-triisocyanatohexane and 1,6,11-triisocyanatoundecane.

The alicyclic isocyanate (iii) may be a monocyclic or polycyclic alicyclic isocyanate. Illustrative examples of the monocyclic alicyclic isocyanate include 1,3-diisocyanato-6-methylcyclohexane, 1,3-diisocyanato-2-methylcyclohexane, 1,4-diisocyanatocyclohexane, 1,4-diisocyanatomethylcyclohexane, 1,3-diisocyanatomethylcyclohexane, 1,4-diisocyanatoethylcyclohexane, 1-isocyanato-3,5,5-trimethyl-3-isocyanatomethylcyclohexane (IPDI), 4,4'-diisocyanatodicyclohexylmethane (H12MDI), 1,3-diisocyanatomethylcyclohexane (m-H6XDI), 1,4-diisocyanatomethylcyclohexane (p-H6XDI), 1-isocyanato-1-methyl-3-isocyanatomethylcyclohexane, 1-isocyanato-1-methyl-4-isocyanatomethylcyclohexane and 1,3,5-triisocyanatomethylcyclohexane.

Illustrative examples of the polycyclic alicyclic isocyanate include 2,5-diisocyanatomethylbicyclo[2.2.1]heptane, 2,6-diisocyanatomethylbicyclo[2.2.1]heptane, 2,5-diisocyanatoethylbicyclo[2.2.1]heptane, 2,6-diisocyanatoethylbicyclo[2.2.1]heptane, 2,5-diisocyanatopropylbicyclo[2.2.1]heptane, 2,6-diisocyanatopropylbicyclo[2.2.1]heptane, 2,5-diisocyanatobutylbicyclo[2.2.1]heptane, 2,6-diisocyanatobutylbicyclo[2.2.1]heptane, 2,5-diisocyanatopentylbicyclo[2.2.1]heptane, 2,6-diisocyanatopentylbicyclo[2.2.1]heptane, 2-isocyanatomethyl-5-isocyanatoethylbicyclo[2.2.1]heptane, 2-isocyanatomethyl-6-isocyanatoethylbicyclo[2.2.1]heptane, 2-isocyanatomethyl-5-isocyanatobutylbicyclo[2.2.1]heptane, 2-isocyanatomethyl-6-isocyanatobutylbicyclo[2.2.1]heptane, 2-isocyanatomethyl-5-isocyanatopentylbicyclo[2.2.1]heptane, 2-isocyanatomethyl-6-isocyanatopentylbicyclo[2.2.1]heptane, 2-isocyanatoethyl-5-isocyanatopropylbicyclo[2.2.1]heptane, 2-isocyanatoethyl-6-isocyanatopropylbicyclo[2.2.1]heptane, 2-isocyanatoethyl-5-isocyanatobutylbicyclo[2.2.1]heptane, 2-isocyanatoethyl-6-isocyanatobutylbicyclo[2.2.1]heptane, 2-isocyanatoethyl-5-isocyanatopentylbicyclo[2.2.1]heptane, 2-isocyanatoethyl-6-isocyanatopentylbicyclo[2.2.1]heptane, 2-isocyanatopropyl-5-isocyanatobutylbicyclo[2.2.1]heptane, 2-isocyanatopropyl-6-isocyanatobutylbicyclo[2.2.1]heptane, 2-isocyanatopropyl-5-isocyanatopentylbicyclo[2.2.1]heptane, 2-isocyanatopropyl-6-isocyanatopentylbicyclo[2.2.1]heptane, 2-isocyanatobutyl-5-isocyanatopentylbicyclo[2.2.1]heptane, 2-isocyanatobutyl-6-isocyanatopentylbicyclo[2.2.1]heptane, 5,5-diisocyanatomethylbicyclo[2.2.2]octane, 6,6-diisocyanatomethylbicyclo[2.2.2]octane, 2-isocyanatomethyl-5-isocyanatoethylbicyclo[2.2.2]octane, 2-isocyanatomethyl-6-isocyanatoethylbicyclo[2.2.2]octane, 2,5-diisocyanatoethylbicyclo[2.2.2]octane, 2,6-diisocyanatoethylbicyclo[2.2.2]octane, 2,5-diisocyanatopropylbicyclo[2.2.2]octane, 2,6-diisocyanatopropylbicyclo[2.2.2]octane, 2,5-diisocyanatobutylbicyclo[2.2.2]octane, 2,6-diisocyanatobutylbicyclo[2.2.2]octane, 2,5-diisocyanatopentylbicyclo[2.2.2]octane, 2,6-diisocyanatopentylbicyclo[2.2.2]octane, 3,8-diisocyanatomethyltricyclo[5.2.1.0^{2,6}]decane, 3,9-diisocyanatomethyltricyclo[5.2.1.0^{2,6}]decane, 4,8-diisocyanatomethyltricyclo[5.2.1.0^{2,6}]decane, 4,9-diisocyanatomethyltricyclo[5.2.1.0^{2,6}]decane, 3-isocyanatomethyl-8-isocyanatoethyltricyclo[5.2.1.0^{2,6}] decane, 3-isocyanatomethyl-9-isocyanatoethyltricyclo[5.2.1.0^{2,6}] decane, 4-isocyanatomethyl-8-isocyanatoethyltricyclo[5.2.1.0^{2,6}] decane, 4-isocyanatomethyl-9-isocyanatoethyltricyclo[5.2.1.0^{2,6}] decane, 3,8-diisocyanatoethyltricyclo[5.2.1.0^{2,6}]decane, 3,9-diisocyanatoethyltricyclo[5.2.1.0^{2,6}]decane, 4,8-diisocyanatoethyltricyclo[5.2.1.0^{2,6}]decane, 4,9-diisocyanatoethyltricyclo[5.2.1.0^{2,6}]decane, 3,8-diisocyanatopropyltricyclo[5.2.1.0^{2,6}]decane, 3,9-diisocyanatopropyltricyclo[5.2.1.0^{2,6}]decane, 4,8-diisocyanatopropyltricyclo[5.2.1.0^{2,6}]decane, 4,9-diisocyanatopropyltricyclo[5.2.1.0^{2,6}]decane, 3,8-diisocyanatobutyltricyclo[5.2.1.0^{2,6}]decane, 3,9-diisocyanatobutyltricyclo[5.2.1.0^{2,6}]decane, 4,8-diisocyanatobutyltricyclo[5.2.1.0^{2,6}]decane, 4,9-diisocyanatobutyltricyclo[5.2.1.0^{2,6}]decane, 3,8-diisocyanatopentyltricyclo[5.2.1.0^{2,6}]decane, 3,9-diisocyanatopentyltricyclo[5.2.1.0^{2,6}]decane, 4,8-diisocyanatopentyltricyclo[5.2.1.0^{2,6}]decane, 4,9-diisocyanatopentyltricyclo[5.2.1.0^{2,6}]decane, 3,7-diisocyanatomethylbicyclo[4.3.0^{1,6}]nonane, 3,8-diisocyanatomethylbicyclo[4.3.0^{1,6}]nonane, 4,7-diisocyanatomethylbicyclo[4,3,0^{1,6}]nonane, 4,8-diisocyanatomethylbicyclo[4.3.0^{1,6}]nonane, 3-isocyanatomethyl-7-isocyanatoethylbicyclo[4.3.0^{1,6}]nonane, 3-isocyanatomethyl-8-isocyanatoethylbicyclo[4.3.0^{1,6}]nonane, 4-isocyanatomethyl-7-isocyanatoethylbicyclo[4.3.0^{1,6}]nonane, 4-isocyanatomethyl-8-isocyanatoethylbicyclo[4.3.0^{1,6}]nonane, 3,7-diisocyanatoethylbicyclo[4.3.0^{1,6}]nonane, 3,8-diisocyanatoethylbicyclo[4.3.0^{1,6}]nonane, 4,7-diisocyanatoethylbicyclo[4.3.0^{1,6}]nonane, 4,8-diisocyanatoethylbicyclo[4.3.0^{1,6}]nonane, 3,7-diisocyanatopropylbicyclo[4.3.0^{1,6}]nonane, 3,8-diisocyanatopropylbicyclo[4.3.0^{1,6}]nonane, 4,7-diisocyanatopropylbicyclo[4.3.0^{1,6}]nonane, 4,8-diisocyanatopropylbicyclo[4.3.0^{1,6}]nonane, 3,7-diisocyanatobutylbicyclo[4.3.0^{1,6}]nonane, 3,8-diisocyanatobutylbicyclo[4.3.0^{1,6}]nonane, 4,7-diisocyanatobutylbicyclo[4.3.0^{1,6}]nonane, 4,8-diisocyanatobutylbicyclo[4.3.0^{1,6}]nonane, 3,7-diisocyanatopentylbicyclo[4.3.0^{1,6}]nonane, 3,8-diisocyanatopentylbicyclo[4.3.0^{1,6}]nonane, 4,7-diisocyanatopentylbicyclo[4.3.0^{1,6}]nonane, 4,8-diisocyanatopentylbicyclo[4.3.0^{1,6}]nonane, 2-isocyanatomethyl-3-isocyanatopropyl-5-isocyanatomethylbicyclo[2.2.1]heptane, 2-isocyanatomethyl-3-isocyanatopropyl-6- isocyanatomethylbicyclo[2.2.1]heptane, 2-isocyanatomethyl-2-isocyanatopropyl-5-isocyanatomethylbicyclo[2.2.1]heptane, 2-isocyanatomethyl-2-isocyanatopropyl-6- isocyanatomethylbicyclo[2.2.1]heptane, 2-isocyanatomethyl-3-isocyanatopropyl-5-isocyanatoethylbicyclo[2.2.1]heptane, 2-isocyanatomethyl-3-isocyanatopropyl-6- isocyanatoethylbicyclo[2.2.1]heptane, 2-isocyanatomethyl-2-isocyanatopropyl-5-isocyanatoethylbicyclo[2.2.1]heptane and 2-isocyanatomethyl-2-isocyanatopropyl-6- isocyanatoethylbicyclo[2.2.1]heptane.

These isocyanates may be used solely or in admixture of two or more as required.

Preferable out of these isocyanates are 1,3-di(isocyanatomethyl)benzene (m-XDI), 1,4-di(isocyanatomethyl)benzene (p-XDI), 1,3-bis(1-isocyanato-1,1-dimethyl)benzene (m-TMXDI), 1,4-bis(1-isocyanato-1,1-dimethyl)benzene (p-TMXDI), 4,4'-diisocyanatodicyclohexylmethane (H12MDI), 1-isocyanato-3,5,5-trimethyl-3-isocyanatomethylcyclohexane (IPDI), 1,3-diisocyanatomethylcyclohexane (m-H6XDI), 1,4-diisocynatomethylcyclohexane (p-H6XDI) and the polycyclic alicyclic isocyanate represented by the formula [I].

Of the above isocyanates, most preferable are 1,3-di(isocyanatomethyl)benzene (m-XDI), 1,4-di(isocyanatomethyl)benzene (p-XDI), 1,3-di(isocyanatomethyl)cyclohexane (m-H6XDI), 1,4-di(isocyanatomethyl)cyclohexane (p-H6XDI), and 2,5-diisocyanatomethylbicyclo[2.2.1]heptane and 2,6-diisocyanatomethylbicyclo[2.2.1]heptane which have a bicyclo ring. These may be used solely or in admixture of two or more.

In addition, the derivatives (vi) of these polyisocyanates, for example, aliphatic and/or alicyclic polyisocyanate derivatives such as isocyanurates, allophanates, carbodiimides, uretdiones and modified urethanes can also be preferably used.

### (Production methods of isocyanates)

Methods for producing the above polyisocyanates are not particularly limited. For example, 2,5-diisocyanatomethylbicyclo[2.2.1]heptane and/or 2,6-diisocyanatomethylbicyclo[2.2.1]heptane can be produced by the method disclosed in Japanese Patent Application Laid-Open No. 220167/1991 which comprises the steps of obtaining the hydrochloride(s) of 2,5-diaminomethylbicyclo[2.2.1]heptane and/or 2,6-diaminomethylbicyclo[2.2.1]heptane from 2,5-diaminomethylbicyclo[2.2.1]heptane and/or 2,6-diaminomethylbicyclo[2.2.1]heptane and a hydrochloric acid gas using a mixed solvent of isoamyl acetate and orthodichlorobenzene, blowing phosgene into the hydrochloride(s) at 160°C in an amount which is about 2.2 times as much as the theoretical amount to cause phosgenation, blowing an inert gas into the system after the completion of the reaction to remove the phosgene in the system, removing the solvent and rectifying the obtained product under reduced pressure.

### (Isocyanate derivatives (vi))

The isocyanate derivatives used in the present invention are generally those obtained by reacting some isocyanate groups of the above isocyanate compound. Illustrative examples of such isocyanate derivatives include uretdiones produced by dimerizing the above isocyanates, isocyanurates produced by trimerizing the above isocyanates, allophanates produced by the reaction of the isocyanates and urethanes, biuret produced by the reaction of the isocyanates and urea, carbodiimides obtained by decarboxylation of two isocyanate groups, and uretonimines produced by the reaction of the carbodiimides and the isocyanates. These may be used either directly in the form of a reaction solution or after unreacted components, the solvent and the like are removed therefrom by a known dropping-type thin-film evaporator or the like.

### (Production methods of isocyanate derivatives)

To produce the above isocyanate derivatives, for example, the isocyanurate produced by trimerizing the isocyanate can be obtained by adding phosphines and the salts of alkali metals such as lithium and potassium to a polyisocyanate, and then reacting the mixture at 20 to 150°C. Meanwhile, the carbodiimide obtained by decarboxylation of two isocyanate groups can be obtained by carrying out a reaction at 150 to 220°C using a trialkylphosphine as a catalyst.

### (Compound having hydroxyl groups which is used for the production of isocyanate group-terminated urethane prepolymer)

As the compound having hydroxyl groups, which is used for preparing the above urethane prepolymer, a compound used for preparing a polyurethane resin obtained from a commonly used isocyanate and a compound having hydroxyl groups such as a polyol can be used.

The compounds having hydroxyl groups, which are used in the present invention, are those having hydroxyl groups that react with isocyanates, as exemplified by water and polyols (compounds having at least two hydroxyl groups in the molecule).

Illustrative examples of the polyols include polyhydric alcohols having a relatively low molecular weight, polyether polyols, polyester polyols, polycarbonate polyols, and modified polyether polyols and polyester polyols.

Specific examples of the polyhydric alcohols having a relatively low molecular weight include dihydric alcohols such as ethylene glycol (EG), diethylene glycol (DEG), propylene glycol (PG), dipropylene glycol (DPG), 1,3-butanediol (1,3-BD), 1,4-butanediol (1,4-BD), 2,2-dimethyl-1,3-propanediol (neopentyl glycol, NPG), 1,5-pentanediol, 1,6-hexanediol, 2,2-dimethyl-1,3-propanediol, 3-methyl-1,5-pentanediol, 2-methyl-2,4-pentanediol, 2-ethyl-1,3-hexanediol, and 1,3-hydroxybenzene, 1,3-bis(2-hydroxyethoxy)benzene, 4,4'-dihydroxydiphenylpropane, 4,4'-dihydroxydiphenylmethane, 1,2-dihydroxycyclohexane, 1,3-dihydroxycyclohexane, 1,4-dihydroxycyclohexane, 1,2-dihydroxymethylcyclohexane, 1,3-dihydroxymethylcyclohexane, 1,4-dihydroxymethylcyclohexane, 1,2-bishydroxyethoxycyclohexane, 1,3-bishydroxyethoxycyclohexane, 1,4-bishydroxyethoxycyclohexane, 1,2-bishydroxyethoxycarbonylcyclohexane, 1,3-bishydroxyethoxycarbonylcyclohexane, 1,4-bishydroxyethoxycarbonylcyclohexane, 2,5-dihydroxymethylbicyclo[2.2.1]heptane, 2,6-dihydroxymethylbicyclo[2.2.1]heptane, 3,8-dihydroxymethyltricyclo[5.2.1.0^{2,6}]decane, 3,9-dihydroxymethyltricyclo[5.2.1.0^{2,6}]decane and 4,8-dihydroxymethyltricyclo[5.2.1.0^{2,6}]decane; trihydric alcohols such as glycerine, 2-hydroxymethyl-2-methyl-1,3-diol, 2-ethyl-2-hydroxymethyl-1,3-diol (TMP), 1,2,5-hexanetriol, 1,2,6-hexanetriol, 1,2,3-cyclohexanetriol and 1,3,5-cyclohexanetriol; and tetrahydric or higher polyhydric alcohols such as pentaerythritol, glucose, sucrose, fructose, sorbitol, 1,2,3,4-cyclohexanetetrol, 1,2,4,5-cyclohexanetetrol, cyclohexanepentol (quercitol), cyclohexanehexol (inositol), and xylitol.

Illustrative examples of the polyether polyols include polyether polyols obtained by addition-polymerizing at least one polyhydric alcohol having a relatively low molecular weight or an aliphatic or aromatic polyamine such as ethylene diamine with at least one compound selected from the group consisting of ethylene oxide, propylene oxide, butylene oxide and styrene oxide; and polytetramethylene ether glycol (PTMEG) obtained by ring-opening polymerizing tetrahydrofuran.

Illustrative examples of the polyester polyols include polyester polyols obtained by polycondensing at least one compound selected from the group consisting of ethylene glycol, propylene glycol, butanediol, pentanediol, hexanediol, glycerine, trimethylolpropane and other low-molecular-weight polyols with at least one compound selected from the group consisting of glutaric acid, adipic acid, sebacic acid, terephthalic acid, isophthalic acid, dimer acid and other low-molecular-weight dicarboxylic acids and oligomer acids or by ring-opening polymerizing caprolactone or the like.

Illustrative examples of the polycarbonate polyols include polycarbonate diols obtained by polycondensation reaction of a polyhydric alcohol such as 1,4-butanediol or 1,6-hexanediol with dimethyl carbonate, diethyl carbonate or the like.

Illustrative examples of the modified polyether polyols and polyester polyols include polymer-dispersed polyols obtained by polymerizing the above known polyether polyol or polyester polyol with an ethylenically unsaturated compound such as acrylonitrile, styrene or methyl methacrylate.

Of the hydroxyl group-containing compounds, polyols are preferable, and polyhydric alcohols having a relatively low molecular weight and polyether polyols are more preferable since the material viscosity is low and the water resistance of the obtained optoelectric conversion device further improves.

These hydroxyl group-containing compounds can be used solely or in combination of two or more as required.

### (Synthesis method of isocyanate group-terminated urethane prepolymer)

A method for synthesizing the isocyanate group-terminated urethane prepolymer is not particularly limited. For example, it can be obtained by charging isocyanate groups which are used in a stoichiometrically excess amount based on hydroxyl groups and a hydroxyl group-containing compound simultaneously or successively and blending them to cause the mixture to react at 10 to 130°C for 1 to 150 hours. Further, a known catalyst may be added to the reaction to increase the rate of the reaction.

### <Component B>

The component (B) associated with the present invention contains a compound having hydroxyl groups and generally contains a compound having at least two hydroxyl groups in a molecule. Of the hydroxyl groups-containing compounds, polyols are preferable.

Further, the hydroxyl group-containing compound contained in the component (B) may be a urethane prepolymer having terminal hydroxyl groups which is obtained by reacting the isocyanate groups with a hydroxyl group-containing compound which is used in a stoichiometrically excess amount in relation to isocyanate groups.

Further, the component (B) may also contain a catalyst, a diluent and a crosslinking agent as required.

Furthermore, the component (B) may also contain a filler, a plasticizer, an antioxidant, an ultraviolet absorber, a light stabilizer and a thermal stabilizer. These other additives may be partially or wholly incorporated into the component (A) without impairing the effect of the present invention.

### ·Polyols

The polyols used in the component (B) may be the same as or different from those used in the urethane prepolymer of the above component (A). They may be used solely or in combination of two or more.

Illustrative examples of the polyols include polyhydric alcohols having a relatively low molecular weight, polyether polyols, polyester polyols, polycarbonate polyols, and modified polyether polyols and polyester polyols.

These polyols can be used solely or in combination of two or more.

### (Polyhydric alcohols)

Specific examples of the polyhydric alcohols having a relatively low molecular weight include dihydric alcohols such as ethylene glycol (EG), diethylene glycol (DEG), propylene glycol (PG), dipropylene glycol (DPG), 1,3-butanediol (1,3-BD), 1,4-butanediol (1,4-BD), 2,2-dimethyl-1,3-propanediol (neopentyl glycol, NPG), 1,5-pentanediol, 1,6-hexanediol, 2,2-dimethyl-1,3-propanediol, 3-methyl-1,5-pentanediol, 2-methyl-2,4-pentanediol, 2-ethyl-1,3-hexanediol and 1,3-hydroxybenzene, 1,3-bis(2-hydroxyethoxy)benzene, 4,4'-dihydroxydiphenylpropane, 4,4'-dihydroxydiphenylmethane, 1,2-dihydroxycyclohexane, 1,3-dihydroxycyclohexane, 1,4-dihydroxycyclohexane, 1,2-dihydroxymethylcyclohexane, 1,3-dihydroxymethylcyclohexane, 1,4-dihydroxymethylcyclohexane, 1,2-bishydroxyethoxycyclohexane, 1,3-bishydroxyethoxycyclohexane, 1,4-bishydroxyethoxycyclohexane, 1,2-bishydroxyethoxycarbonylcyclohexane, 1,3-bishydroxyethoxycarbonylcyclohexane, 1,4-bishydroxyethoxycarbonylcyclohexane, 2,5-dihydroxymethylbicyclo[2.2.1]heptane, 2,6-dihydroxymethylbicyclo[2.2.1]heptane, 3,8-dihydroxymethyltricyclo[5.2.1.0^{2,6}]decane, 3,9-dihydroxymethyltricyclo[5.2.1.0^{2,6}]decane and 4,8-dihydroxymethyltricyclo[5.2.1.0^{2,6}]decane; trihydric alcohols such as glycerine, 2-hydroxymethyl-2-methyl-1,3-diol, 2-ethyl-2-hydroxymethyl-1,3-diol (TMP), 1,2,5-hexanetriol, 1,2,6-hexanetriol, 1,2,3-cyclohexanetriol and 1,3,5-cyclohexanetriol; and tetrahydric or higher polyhydric alcohols such as pentaerythritol, glucose, sucrose, fructose, sorbitol, 1,2,3,4-cyclohexanetetrol, 1,2,4,5-cyclohexanetetrol, cyclohexanepentol (quercitol), cyclohexanehexol (inositol), xylitol, dipentaerythritol and diglycerine.

### (Polyether polyols)

Illustrative examples of the polyether polyols include polyether polyols obtained by addition-polymerizing at least one polyhydric alcohol having a relatively low molecular weight or an aliphatic or aromatic polyamine such as ethylene diamine with at least one compound selected from the group consisting of ethylene oxide, propylene oxide, butylene oxide and styrene oxide; and polytetramethylene ether glycol (PTMEG) obtained by ring-opening polymerizing tetrahydrofuran. Those having a hydroxyl value of 50 to 1,000 mgKOH/g are preferable. Illustrative examples of the method for producing the polyether polyol include a method in which anionic polymerization is carried out in the presence of a base catalyst such as lithium hydroxide, sodium hydroxide, potassium hydroxide or cesium hydroxide to obtain a crude polyol and the catalyst is then removed by rinsing the crude polyol with water or acid. Alternatively, the polyether polyol can also be obtained by a method disclosed in WO 00/23500 in which the addition polymerization of an alkylene oxide is carried out using a compound having a P=N bond in the molecule such as a phosphazene compound, phosphazenium compound or phosphine oxide compound as a catalyst to obtain a crude polyether polyol and the catalyst is removed from the crude polyol by using at least one absorbent selected from the group consisting of aluminum silicate, magnesium silicate and silica gel.

As the polyols used in the component (B) of the present invention, polyhydric alcohols and polyether polyols are preferable.

Particularly, to prepare the polyether polyols, a method using an alkali metal compound as a catalyst is most widely used. In that case, the compound having at least two hydroxyl groups which is used in the component (B) in the present invention preferably contains the alkali metal components in the alkali metal compound in an amount of preferably 10 ppm or less, more preferably 5 ppm or less, most preferably 3 ppm or less. When the content of the alkali metal components is higher than 10 ppm, the leakage of electricity by ions is liable to occur at the time of passing a current, and electric characteristics are liable to deteriorate. When the content of the alkali metal components is 10 ppm or less, the reactivity at the time of mixing the components (A) and (B) by stirring is stabilized, and not only the weathering stability of the resin but also the weathering stability and electric characteristics thereof when used to seal an LED to form a lamp improve advantageously.

The following compounds can be exemplified as the polyols other than the polyether polyols.

### (Polyester polyols)

Illustrative examples of the polyester polyols include polyester polyols obtained by polycondensing at least one compound selected from the group consisting of ethylene glycol, propylene glycol, butanediol, pentanediol, hexanediol, glycerine, trimethylolpropane and other low-molecular-weight polyols with at least one compound selected from the group consisting of glutaric acid, adipic acid, sebacic acid, terephthalic acid, isophthalic acid, dimer acid and other low-molecular-weight dicarboxylic acids and oligomer acids or by ring-opening polymerizing caprolactone or the like.

### (Polycaprolactone polyols)

Illustrative examples of the polycaprolactone polyols include polyols obtained from ε-caprolactone and polyhydric alcohols. The polyols generally have a number average molecular weight of 500 to 4,000 and a hydroxyl value of about 30 to 240 mgKOH/g. As the polyhydric alcohols, those used in the above polyester polyols can be used.

### (Polycarbonate polyols)

Illustrative examples of the polycarbonate polyols include straight-chain aliphatic diols obtained by polycondensation reaction of a polyhydric alcohol such as 1,4-butanediol or 1,6-hexanediol with dimethyl carbonate, diethyl carbonate or the like. The straight-chain aliphatic diols generally have a hydroxyl value of about 60 to 200 mgKOH/g.

### (Modified polyether polyols and modified polyester polyols)

Illustrative examples of the modified polyether polyols and modified polyester polyols include polymer polyols obtained by polymerizing the above known polyether polyol or polyester polyol with an ethylenically unsaturated compound such as acrylonitrile, styrene or methyl methacrylate.

### (Polymer-dispersed polyols)

As the polyether polyol in the present invention, a polymer-dispersed polyol may be used. This polymer-dispersed polyol is a vinyl polymer particle-dispersed polyol obtained by dispersion-polymerizing an ethylenically unsaturated group-containing monomer such as acrylonitrile or styrene with a radical initiator such as azobisisobutyronitrile in a polyether polyol. The content of the polymer in the polyether polyol is about 2 to 50% by weight. When used in the present invention, a polymer-dispersed polyol having a polymer content of 10 to 40% by weight is preferable. A polymer-dispersed polyol containing styrene as the vinyl polymer in an amount of at least 30% by weight is preferable.

### (Synthesis method of hydroxyl group-terminated urethane prepolymer)

A method for synthesizing a hydroxyl group-terminated urethane prepolymer is not particularly limited, and the prepolymer may be synthesized by the same method as used for synthesizing the isocyanate group-terminated urethane prepolymer. For example, it can be obtained by charging isocyanate groups which are used in a stoichiometrically excess amount based on hydroxyl groups and an isocyanate group-containing compound simultaneously or successively and blending them to cause the mixture to react at 10 to 130°C for 1 to 150 hours.

Further, a known catalyst may be added to the reaction to increase the rate of the reaction.

### (Catalysts)

Illustrative examples of the catalyst used as required in the reaction of the isocyanate group-containing compound and the hydroxyl group-containing compound in the present invention include organometallic catalysts such as organotin compounds, e.g., dibutyltin dilaurate, dioctyltin maleate, stannous octoate and dibutyltin oxide, organic titanium compounds, e.g., tetrabutyl titanate, organolead compounds, e.g., lead naphthenate and lead octoate, and organic bismuth compounds, e.g., bismuth neodecanoate and bismuth octoate; and tertiary amines such as triethylenediamine, triethylamine, tetramethylenediamine, N-methylmorpholine, N,N-dimethylethanolamine and dimethylimidazole. These catalysts can be used solely or in combination of two or more.

Of these, the organometallic catalysts are preferable, and the organotin compounds are more preferable. The catalysts are used in an amount of 0.001 to 5% by weight, preferably 0.01 to 2% by weight, based on the isocyanate compound. However, it is more preferable not to use the catalysts in producing a light-emitting diode lamp.

### (Diluent)

The diluent used as required in the reaction of the isocyanate group-containing compound and the hydroxyl group-containing compound in the present invention is not particularly limited. Preferable examples of the diluent include those having a relatively high boiling point and capable of securing compatibility, such as ethyl acetate, butyl acetate, 2-butanone, petroleum ether, n-hexane, toluene, xylene and mineral spirit.

### (Crosslinking agent)

The crosslinking agent used as required in the present invention is not particularly limited and may be one which is generally used in the production of a polyurethane resin composition. Illustrative examples of such a crosslinking agent include polyamines such as di(aminomethyl)benzene, 1-amino-3,5,5-trimethyl-3-aminomethylcyclohexane, bis(aminomethyl)bicyclo[2.2.1]heptane, diaminodiphenylmethane and polymeric materials thereof.

These catalysts, diluents and crosslinking agents may be used in the production of the urethane resin as required.

### [Production method of urethane resin for optoelectric conversion element sealer]

The urethane resin for an optoelectric conversion element sealer according to the present invention can be produced by mixing and reacting the component (A) containing the compound having isocyanate groups with the component (B) containing the compound having hydroxyl groups.

Further, to prevent air bubbles from entering the urethane resin for an optoelectric conversion element sealer of the present invention, it is preferable that the material composition be fully deaerated under reduced pressure. The conditions for the deaeration are not particularly limited. For example, the deaeration can be carried out at 10 to 100°C and 30 kPa or lower for 3 to 60 minutes.

Furthermore, the less the content of water in the component (B), the more preferable it is. The content of water in the polyol in the component (B) is preferably 500 ppm or less, more preferably 300 ppm or less, most preferably 200 ppm or less.

Furthermore, the less the contents of water in other auxiliaries, the more preferable it is. The polyol and other auxiliaries are preferably dehydrated under reduced pressure before use.

The mixing method is not particularly limited. The component (A) and the component (B) may be stirred, mixed and discharged under low pressure using a static mixer or the like or collision-mixed under high pressure. Further, since at least one isocyanate selected from the group consisting of an aromatic isocyanate having a structure in which isocyanates are not directly bonded to the benzene ring, an aliphatic isocyanate, an alicyclic isocyanate and derivatives of these isocyanates is used in the urethane resin composition for an optoelectric conversion element sealer of the present invention, the reaction is moderate, and after the component (A) and the component (B) are mixed together in advance, a necessary amount can be taken out of the mixture stored in a reservoir or the like and used.

When two or more polyols are used in the component (B), the component (B) is preferably mixed with the component (A) containing a compound having isocyanate groups after the polyols are mixed together. It is more preferable that the polyols be compatible one another.

The mixing ratio of the component (A) containing a compound having isocyanate groups and the component (B) containing a compound having hydroxyl groups is such that the molar ratio (NCO/OH ratio) of the isocyanate groups in the component (A) and the hydroxyl groups in the component (B) is generally 0.5 to 2.5, preferably 0.6 to 1.8, more preferably 0.8 to 1.3.

The molding (curing) temperature is not particularly limited but is generally 5 to 220°C, preferably 20 to 200°C, more preferably 40 to 180°C.

The molding time is preferably 1 minute to 10 hours, more preferably 1 to 7 hours. Further, after-curing is preferably carried out at 40 to 180°C for 1 to 12 hours.

### [Optoelectric conversion device and production method thereof]

The optoelectric conversion element used in the optoelectric conversion device of the present invention is not particularly limited and is exemplified by a light-emitting diode, a semiconductor laser, a photodiode, a phototransistor, an electroluminescent element, a CCD and a solar battery.

The optoelectric conversion device of the present invention can be produced according to application purposes by mixing the component (A) containing a compound having isocyanate groups and the component (B) containing a compound having hydroxyl groups to prepare a resin composition, applying the composition to the target portions of the optoelectric conversion element'and curing the applied composition to seal the optoelectric conversion element.

### <Light-emitting or light-receiving device and production method thereof>

The light-emitting or the light-receiving element used in the light-emitting or the light-receiving device according to the present invention is not particularly limited and is exemplified by a light-emitting diode, a semiconductor laser, a photodiode, a phototransistor, an electroluminescent element and a CCD which can also be used in the above optoelectric conversion device.

The light-emitting or the light-receiving device of the present invention can be produced according to application purposes by mixing the component (A) containing a compound having isocyanate groups and the component (B) containing a compound having hydroxyl groups to prepare a resin composition, applying the composition to the target portions of the light-emitting or the light-receiving element and curing the applied composition to seal the light-emitting or the light-receiving element.

### <Light-emitting diode (LED) lamp and production method thereof>

The light-emitting diode (LED) lamp according to the present invention is obtained by sealing a light-emitting diode in a mold by use of a preparation obtained by adding additives such as antioxidants, ultraviolet absorbers, light stabilizers and thermal stabilizers, as exemplified by "IRGANOX" #1010 and #1076 (registered trademarks of Ciba Specialty Chemicals), "YOSHINOX" BHT, BB and GSY-930 (registered trademarks of Welfide Corporation), "TINUVIN" 327, 328 and B-75 (registered.trademarks of Ciba Specialty Chemicals), "TOMISORB" 800 (registered trademarks of Welfide Corporation, products of Yoshitomi Fine Chemicals), "SANOL" LS-770, 744 and 765 (registered trademarks of Sankyo Co., Ltd.) and "SUMILIZER" GA-80 (registered trademark of Sumitomo Chemical Industries, Ltd.), arbitrarily to the urethane resin composition for an optoelectric conversion element sealer which comprises the component (A) containing a compound having isocyanate groups and the component (B) having hydroxyl groups; and curing the applied preparation. These additives such as antioxidants, ultratiolet absorbers, light stabilizers and thermal stabilizers may be mixed into the component (A) or the component (B) in advance or added separately from the components (A) and (B). These additives are generally added to the component (B).

The material of the mold for producing the light-emitting diode is not particularly limited, and a metal, glass, a resin or the like may be used. However, in consideration of releasing the cured light-emitting diode lamp from the mold, it is preferable to coat the metal or glass with a fluorocarbon resin or a mold-releasing agent before use or to use a mold made of a resin having good releasability such as polypropylene.

Further, the shape of the mold is also not particularly limited and may be any shape which can suitably use the light emitted from the light-emitting diode. Illustrative examples of the shape of the mold include a circle, triangle, rectangle, cube and cuboid.

The light-emitting diode used in the present invention is not particularly limited and is exemplified by those using compound semiconductors such as GaAs, GaAlAs, GaP, GaAsP, ZnSe, ZnS and GaN. Further, the color of the light from the light-emitting diode is not particularly limited and is red, green, blue, yellow, orange, yellow-green or white.

The light-emitting diode lamp of the present invention may not have to be only a so-called "lamp" type and may-also be a "surface-mounted" type.

The light-emitting diode (LED) lamp of the present invention can be produced by placing a light-emitting diode in a mold in advance, charging the urethane resin composition for an optoelectric conversion element. sealer of the present invention which comprises the component (A) containing a compound having isocyanate groups and the. component (B) having hydroxyl groups and curing the charged composition at room temperature or under heat or by charging the urethane resin composition for an optoelectric conversion element sealer of the present invention which comprises the component (A) containing a compound having isocyanate groups and the component (B) having hydroxyl groups into a mold, immersing a light-emitting diode in the charged composition and curing the charged composition at room temperature or under heat.

The present invention will be further described with reference to Examples and Comparative Examples hereinafter. The present invention, however, shall not be limited to the Examples and Comparative Examples. Further, in the present invention, "%" and the like represent "% by weight", unless otherwise stated.

### (Evaluations and testing methods)

By the following methods, IR measurement, hardness, glass transition temperature (and elastic modulus), impact resistance, refractive index (and Abbe number), weathering stability, (test for resistance to high temperature and high moisture), (water absorption) and pot life were measured.

### <Analysis of polyether polyol>

### (1) Measurements of the hydroxyl value of polyol and the amount of residual potassium in the polyol

The hydroxyl value (unit: mgKOH/g) of a polyol was measured in accordance with JIS K-1557. The amount (unit: ppm) of residual potassium in the polyol was determined by using an atomic absorption analyzer (product of PerkinElmer, Inc., model: 5100PC). The limit of determination was 0.1 ppm.

### <Analysis of the content (NCO%) of isocyanate groups in isocyanate group-containing compound>

This was measured in accordance with JIS K-1556.

### <Measurements of the physical properties of urethane resin and urethane resin composition for optoelectric conversion element sealer>

### (1) Measurement of content of sulfur atoms

Sulfur atoms were combusted to be decomposed into sulfur dioxide, and the sulfur dioxide was absorbed by a titration cell and determined by an elementary analysis method (product of Mitsubishi Chemical Corporation, model: TSX-10) in which titration was carried out by using a platinum electrode. The limit of determination was 100 ppm.

### (2) Measurement of amount of potassium

This was determined by an atomic absorption analyzer (product of Hitachi, Ltd., model: Z-5000) using a graphite furnace. The limit of determination was 0.05 ppm.

### (3) IR measurement

The peak of an isocyanate group at 2,270 cm⁻¹ was traced by using the infrared spectrophotometer of Shimadzu Corporation to examine the degree of completion of the reaction.

### (4) Hardness

This was measured by using a Shore A-type or Shore D-type Durometer.

### (5) Glass transition temperature and elastic modulus

They were measured at a frequency of 5 Hz and a temperature-increasing rate of 5°C/min by using a solid viscoelasticity measuring device (product of Seiko Instruments Inc.). The peak of tan δ was taken as the glass transition temperature (Tg). The storage elastic modulus at 30°C was taken as the elastic modulus.

### (6) Impact resistance

A sample which was molded into a button shape defined in JIS K-6262 was dropped on a concrete surface from 2 meters above, and the condition of the dropped sample was examined.

### (7) Refractive index

This was measured at 20°C by using a Pulfrich refractometer. The refractive index measured by using a D line (587.6 mm) from a helium light source was taken as the value of the refractive index.

### (8) Weathering stability

A sample was irradiated with light by using a sunshine weatherometer equipped with a carbon arc lamp for 600 hours, and the sample was then examined for yellowing. The degree of yellowing was determined by measuring the color difference (ΔE) using the C-5120 hue and color-difference meter of Tokyo Denshoku Co., Ltd.

### (9) Test for resistance to high temperature and high moisture

A cured sample piece having a size of 50 mm x 50 mm x 2 mm was left to stand for 300 hours in a thermostatic chamber having a temperature of 80°C and a relative humidity of 90%, and a change in the appearance (or degree of yellowing) of the sample was then observed. The degree of yellowing was determined by measuring the color difference (ΔE) using the C-5120 hue and color-difference meter of Tokyo Denshoku Co., Ltd.

### (10) Water absorption

This was measured by using the method (method for testing the water absorption and boiling water absorption of plastic) described in JIS K-7209. The size of a sample was 50 mm x 50 mm x 2 mm.

### (11) Pot life

The component (A) containing a compound having isocyanate groups and the component (B) containing a compound having hydroxyl groups were measured to a total of 100 g in a chamber having a temperature of 20°C and a relative humidity of 50% and stirred for 10 minutes. Thereafter, the time required for the viscosity at 5 minutes from the start of mixing to become twice as much was measured by a B8M-type rotating viscometer and taken as the pot life.

### <Evaluation and testing method of light-emitting diode lamp>

### (1) Appearance after light-resistance test

A cured light-emitting diode lamp was left to stand for 300 hours in a thermostatic chamber having a temperature of 80°C and a relative humidity of 90%, and a change in the appearance (or degree of yellowing) of the sample was then observed. The degree of yellowing was determined by measuring the color difference (ΔE) using the C-5120 hue and color-difference meter of Tokyo Denshoku Co., Ltd. The ΔE was evaluated as "O" when it is 1.5 or less and "X". when it is higher than 1.5.

### Preparation of materials to be used

### Preparation Example 1 [Synthesis of polyol A]

680.2 Grams of pentaerythritol and 86.23 g of potassium hydroxide were charged into a pressure autoclave (to be simply referred to as "autoclave" hereinafter) equipped with a stirrer,. temperature controller, manometer, nitrogen-introducing pipe and monomer-introducing pipe in a nitrogen atmosphere. Then, the inside of the autoclave was substituted with nitrogen at room temperature, thereby reducing the internal pressure to 6.55 kPa. Thereafter, 897.3 g of propylene oxide was charged at a time, the mixture was gradually heated to 115°C under agitation, and the reaction was allowed to continue at the same temperature until no change in the pressure of the autoclave was observed. Then, the pressure of the autoclave was reduced at the same temperature and 665 Pa for 30 minutes, unreacted propylene oxide was recovered, and a crude polyol A was obtained.

Then, the crude polyol A was charged into a separable flask (to be simply referred to as "separable flask" hereinafter) equipped with a thermometer, stirrer, water-cooled condenser, nitrogen-introducing pipe and decompression line and heated to 80°C. At the temperature, 1.03 moles of oxalic acid (5% by weight, in the form of an aqueous solution) was added per mole of potassium hydroxide in the crude polyol A, and the reaction was carried out at the same temperature for 3 hours. Thereafter, the temperature was increased and the pressure was reduced, and eventually the same procedure was carried out at 110°C and 1.33 kPa or lower for 3 hours. Then, filtration under reduced pressure was carried out by use of filter paper having a retention particle diameter of 1 µm to recover a polyol. The hydroxyl value of the obtained polyol A was 793.5 mgKOH/g and the amount of potassium remaining in the polyol A was 1.5 ppm.

The polyols used in the following examples were synthesized in accordance with the above procedure and the hydroxyl values thereof and the amounts of potassium remaining in the polyols were determined by the above method.

### Preparation Example 2 [Synthesis of isocyanate group-terminated urethane prepolymer (A-1)]

To a 1-liter separable flask equipped with a stirrer which had been dried and nitrogen-substituted, 893.4 g of " 'COSMONATE'(registered trademark)NBDI" (mixture of 2,5-diisocyanatomethylbicyclo[2.2.1]heptane and 2,6-diisocyanatomethylbicyclo[2.2.1]heptane, product of Mitsui Chemicals, Inc. to be referred to as "NBDI" hereinafter) was charged, and 106.6 g of the polyol A obtained in Preparation Example 1 was added thereto. The mixture was allowed to react at 100°C under a current of nitrogen for 8 hours and then allowed to age at room temperature for one day, thereby obtaining an isocyanate group-terminated urethane prepolymer (A-1) having an NCO% of 30.0.

### Preparation Example 3 [Synthesis of isocyanate group-terminated urethane prepolymer (A-2)]

833.6 Grams of NBDI was charged into the same apparatus as in the preparation of the isocyanate group-terminated urethane prepolymer of the above Preparation Example 1, and 166.4 g of the polyol A obtained in Preparation Example 1 was added thereto. The mixture was allowed to react at 100° C under a current of nitrogen for 8 hours and then allowed to age at room temperature for one day, thereby obtaining an isocyanate group-terminated urethane prepolymer (A-2) having an NCO% of 24.0.

### Preparation Example 4 [Synthesis of isocyanate group-terminated urethane prepolymer (A-3)]

776.3 Grams of " 'COSMONATE'(registered trademark)T-80" (mixture of 2,4-tolylenediisocyanate and 2,6-tolylenediisocyanate in a weight ratio of 80/20, product of Mitsui Chemicals, Inc.) was charged into the same apparatus as in the preparation of the isocyanate group-terminated urethane prepolymer of the above Preparation Example 1, and 223.7 g of the polyol A obtained in Preparation Example 1 was added thereto. The mixture was allowed to react at 100°C under a current of nitrogen for 3 hours and then allowed to age at room temperature for one day, thereby obtaining an isocyanate group-terminated urethane prepolymer (A-3) having an NCO% of 24.0.

### Preparation Example 5 [Synthesis of isocyanate group-terminated urethane prepolymer (A-4)]

898.0 Grams of " 'COSMONATE'(registered trademark)PH" (4,4'-diphenylmethanediisocyanate, product of Mitsui Chemicals, Inc.) was charged into the same apparatus as in the preparation of the isocyanate group-terminated urethane prepolymer of the above Preparation Example 1, and 102.0 g of the polyol A obtained in Preparation Example 1 was added thereto. The mixture was allowed to react at 100°C under a current of nitrogen for 3 hours, thereby obtaining an isocyanate group-terminated urethane prepolymer (A-4) having an NCO% of 24.0.

### Preparation Example 6 [Synthesis of isocyanate group-terminated urethane prepolymer (A-5)]

802.4 Grams of " 'TAKEMATE'(registered trademark)500" (1,3-di(isocyanatomethyl)benzene, product of Takeda Chemical Industries, Ltd.) was charged into the same apparatus as in the preparation of the isocyanate group-terminated urethane prepolymer of the above Preparation Example 1, and 197.6 g of the polyol A obtained in Preparation Example 1 was added thereto. The mixture was allowed to react at 100°C under a current of nitrogen for 3 hours and then allowed to age at room temperature for one day, thereby obtaining an isocyanate group-terminated urethane prepolymer (A-5) having an NCO% of 24.0.

### Preparation Example 7 [Synthesis of isocyanate group-terminated urethane prepolymer (A-6)]

186.5 Grams of " 'TAKENATE'(registered trademark)600" (1,3-di(isocyanatomethyl)cyclohexane, product of Takeda Chemical Industries, Ltd.) was charged into the same apparatus as in the preparation of the isocyanate group-terminated urethane prepolymer of the above Preparation Example 1, and 186.5 g of the polyol A obtained in Preparation Example 1 was added thereto. The mixture was allowed to react at 100°C under a current of nitrogen for 8 hours and then allowed to age at room temperature for one day, thereby obtaining an isocyanate group-terminated urethane prepolymer (A-6) having an NCO% of 24.0.

### Preparation Example 8 [Synthesis of isocyanurate derivative-containing polyisocyanate compound (A-7)]

An isocyanurate derivative-containing polyisocyanate compound (A-7) was prepared by the method disclosed in Japanese Patent Application Laid-Open No. 302351/1999. That is, 3.0 g of 2-ethylhexane-1,3-diol was added to 3.0 g of 10% tetrabutylammonium hydroxide/methanol solution and stirred. While the mixture was stirred, methanol was removed by distilling off under reduced pressure, and 2-ethylhexane-1,3-diol was then added to prepare a trimerization catalyst solution having a concentration of about 1%. 300 Grams of NBDI was charged into a 500-ml separable flask equipped with a cooling pipe, thermometer, dropping funnel and stirrer, and while the solution was stirred in a nitrogen atmosphere with the solution temperature maintained at 60°C, the trimerization catalyst solution was added dropwise. Since the rate of conversion into a trimer exceeded 40% at about 60 minutes after the start of the reaction, the trimerization reaction was terminated by increasing the solution temperature to 100°C and stirring the mixture for 30 minutes. After the solution was cooled to room temperature, an unreacted NBDI monomer was removed by using a dropping molecular distiller at 150°C and 6.7 Pa. The obtained A-7 had an NCO% of 17.6.

The following procedures were carried out in a thermostatic and hydrostatic chamber having a temperature of 25°C and a relative humidity of 50%.

### Example 1

100.0 Grams of NBDI was charged into a stainless cup. While the NBDI was stirred by stirrer, 62.3 g of a polyol (to be referred to as "polyol B" hereinafter) which is obtained by adding propylene oxide (to be referred to as "PO" hereinafter) to 1 mole of 2-ethyl-2-hydroxymethyl-1,3-diol (to be referred to as "TMP" hereinafter) and which has a hydroxyl value of 874 mgKOH/g and a residual potassium amount of 0.9 ppm was added to the NBDI without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 2

100.0 Grams of NBDI was charged into the same stainless cup as in Example 1. While the NBDI was stirred, 91.4 g of a polyol obtained by adding PO to TMP and having a hydroxyl value of 874 mgKOH/g and a residual potassium amount of 1.1 ppm was added to the NBDI without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 3

100.0 Grams of NBDI was charged into the same stainless cup as in Example 1. While the NBDI was stirred, 117.9 g of a polyol obtained by adding PO to dipentaerythritol and having a hydroxyl value of 462 mgKOH/g and a residual potassium amount of 1.3 ppm was added to the NBDI without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 4

66.0 Grams of NBDI was added to 44.0 g of the isocyanurate derivative-containing polyisocyanate compound (A-7) obtained in Preparation Example 8 and stirred to be dissolved, thereby preparing 110.0 g of an isocyanate compound having an NCO% of 31.5. 100.0 Grams of the polyisocyanate compound was charged into the same stainless cup as in Example 1. While the polyisocyanate compound was stirred by stirrer, 48.1 g of the polyol B was added thereto without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 5

100.0 Grams of the isocyanate group-terminated urethane prepolymer (A-1) synthesized in Preparation Example 2 were charged into the same stainless cup as in Example 1. While the prepolymer (A-1) was stirred, 45.8 g of the polyol B was added thereto without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 6

100.0 Grams of the isocyanate group-terminated urethane prepolymer (A-2) synthesized in Preparation Example 3 was charged into the same stainless cup as in Example 1. While the prepolymer (A-2) was stirred, 36.7 g of the polyol B was added thereto without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 7

100.0 Grams of the isocyanate group-terminated urethane prepolymer (A-5) synthesized in Preparation Example 6 was charged into the same stainless cup as in Example 1. While the prepolymer (A-5) was stirred, 36.7 g of the polyol B was added thereto without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 8

100.0 Grams of the isocyanate group-terminated urethane prepolymer (A-6) synthesized in Preparation Example 7 was charged into the same stainless cup as in Example 1. While the prepolymer (A-6) was stirred, 36.7 g of the polyol B was added thereto without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Example 9

While 100.0 g of NBDI was stirred at 25°C, 71.0 g of 2-ethyl-1,3-hexanediol was added to the NBDI. They were stirred and mixed for 10 minutes to be dissolved homogeneously. The homogeneous solution was transferred into a mold, allowed to react in an oven heated to 100°C in a nitrogen gas atmosphere for 5 hours and then after-cured at 150°C for 3 hours to obtain a colorless, transparent polyurethane resin.

### Example 10

While 127.8 g of 2-ethyl-1,3-hexanediol was stirred at 25°C, 5.96 g of glycerine was added, thereby obtaining a polyol mixed solution (C). While 100.0 g of NBDI was stirred at 25°C, 66.9 g of the polyol mixed solution (C) was added. After stirred and mixed for 10 minutes to be dissolved homogeneously, they were allowed to react at 100°C for 5 hours and after-cured at 150°C for 3 hours in the same manner as in Example 1to obtain a colorless, transparent polyurethane resin.

### Example 11

While 127.8 g of 2-ethyl-1,3-hexanediol was stirred at 25°C, 11.5 g of 1,4-hexanediol was added, thereby obtaining 139.3 g of a polyol mixed solution (D). While 100.0 g of NBDI was stirred at 25°C, 69.6 g of the polyol mixed solution (D) was added. After stirred and mixed for 10 minutes to be dissolved homogeneously, they were allowed to react at 100°C for 5 hours and after-cured at 150°C for 3 hours in the same manner as in Example 1 to obtain a colorless, transparent polyurethane resin.

### Comparative Example 1

A polyurethane resin was obtained in the same manner as in Example 1 except that 100.0 g of " 'COSMONATE'(registered trademark)T-80" (product of Mitsui Chemicals, Inc.) was used as the isocyanate group-containing component (A) and 73.7 g of the polyol B was used as the component (B).

### Comparative Example 2

100.0 g of " 'COSMONATE'(registered trademark)PH" (product of Mitsui Chemicals, Inc.) which had been dissolved in advance was used as the isocyanate group-containing component (A) and 51.3 g of the polyol B was used as the component (B). As soon as mixing was started, "COSMONATE PH" was precipitated and the mixture could not be stirred.

### Comparative Example 3

A polyurethane resin was obtained in the same manner as in Example 1 except that 100.0 g of the A-3 synthesized in Preparation Example 4 was used as the isocyanate group-containing component (A) and 36.7 g of the polyol B used in Example 1 was used as the component (B).

### Comparative Example 4

A polyurethane resin was obtained in the same manner as in Example 1 except that 100.0 g of the A-4 synthesized in Preparation Example 5 was used as the isocyanate group-containing component (A) and 36.7 g of the polyol B used in Example 1 was used as the component (B).

### Comparative Example 5

100.0 Grams of 1,3-di(isocyanatomethyl)benzene was charged into a stainless cup. While the compound was stirred by stirrer, 129.8 g of pentaerythritol tetrakis(3-mercaptopropionate) was added to the compound without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

### Comparative Example 6

100.0 Grams of NBDI was charged into a stainless cup. While the NBDI was stirred by stirrer, 118.6 g of pentaerythritol tetrakis(3-mercaptopropionate) was added to the NBDI without taking in bubbles, and they were stirred and mixed for 10 minutes to be dissolved homogeneously. The homogeneous solution was transferred into a mold having a size of 50 mm x 50 mm, allowed to react in an oven heated to 100°C in a nitrogen gas atmosphere for 5 hours and then after-cured at 150°C for 3 hours to obtain a colorless, transparent polyurethane resin.

In Examples 1 to 11 and Comparative Examples 1 to 6, no absorption peaks associated with isocyanate groups were observed in IR measurement.

Further, while the contents of sulfur atoms in Examples 1 to 11 and Comparative Examples 1 to 4 were less than or equal to a detection limit, the contents of sulfur atoms in Comparative Examples 5 and 6 were 14%.

The measurement results of the urethane resins obtained in Examples 1 to 11 and Comparative Examples 1 to 6 are shown in Tables 1 and 2.

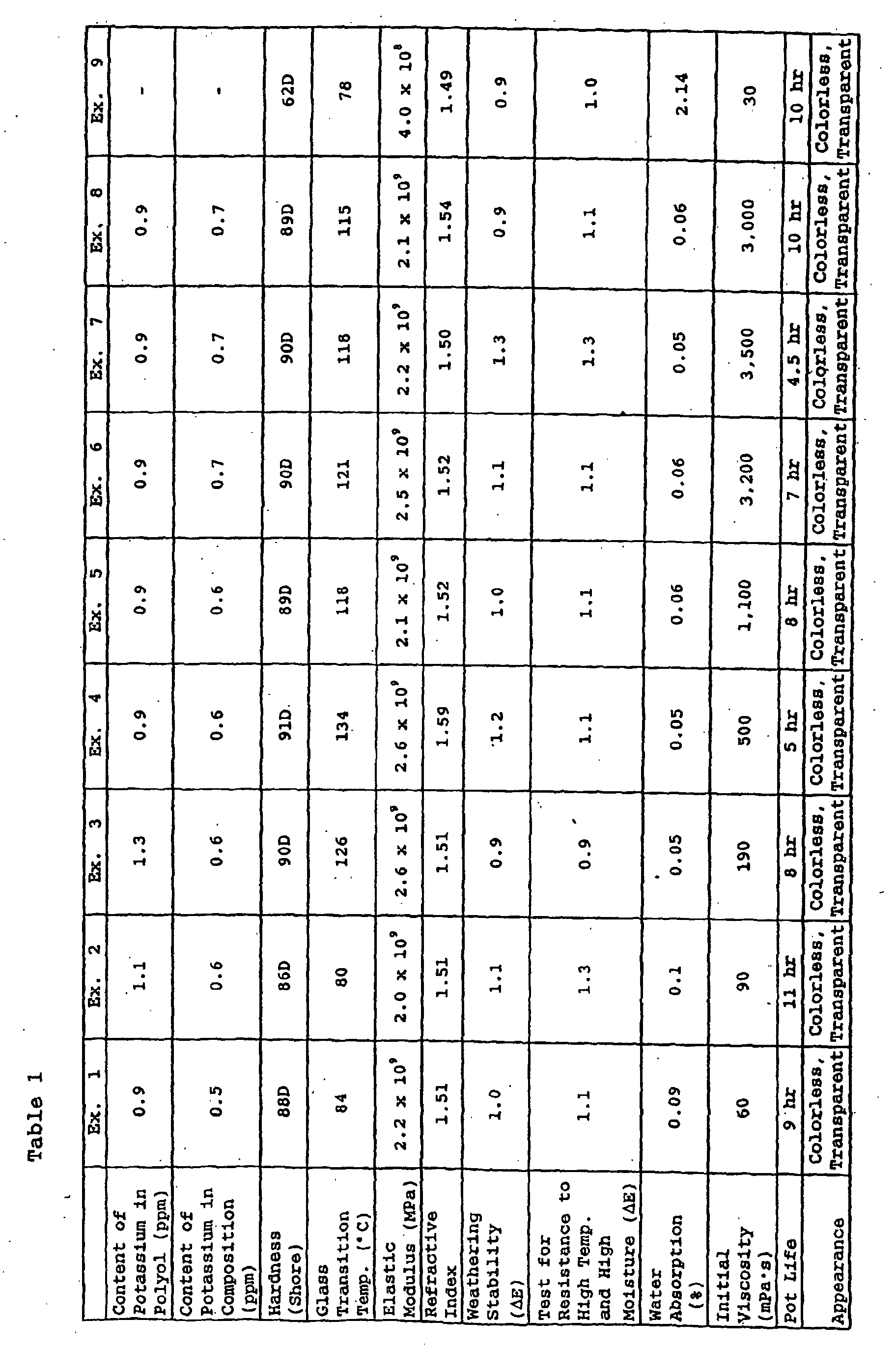

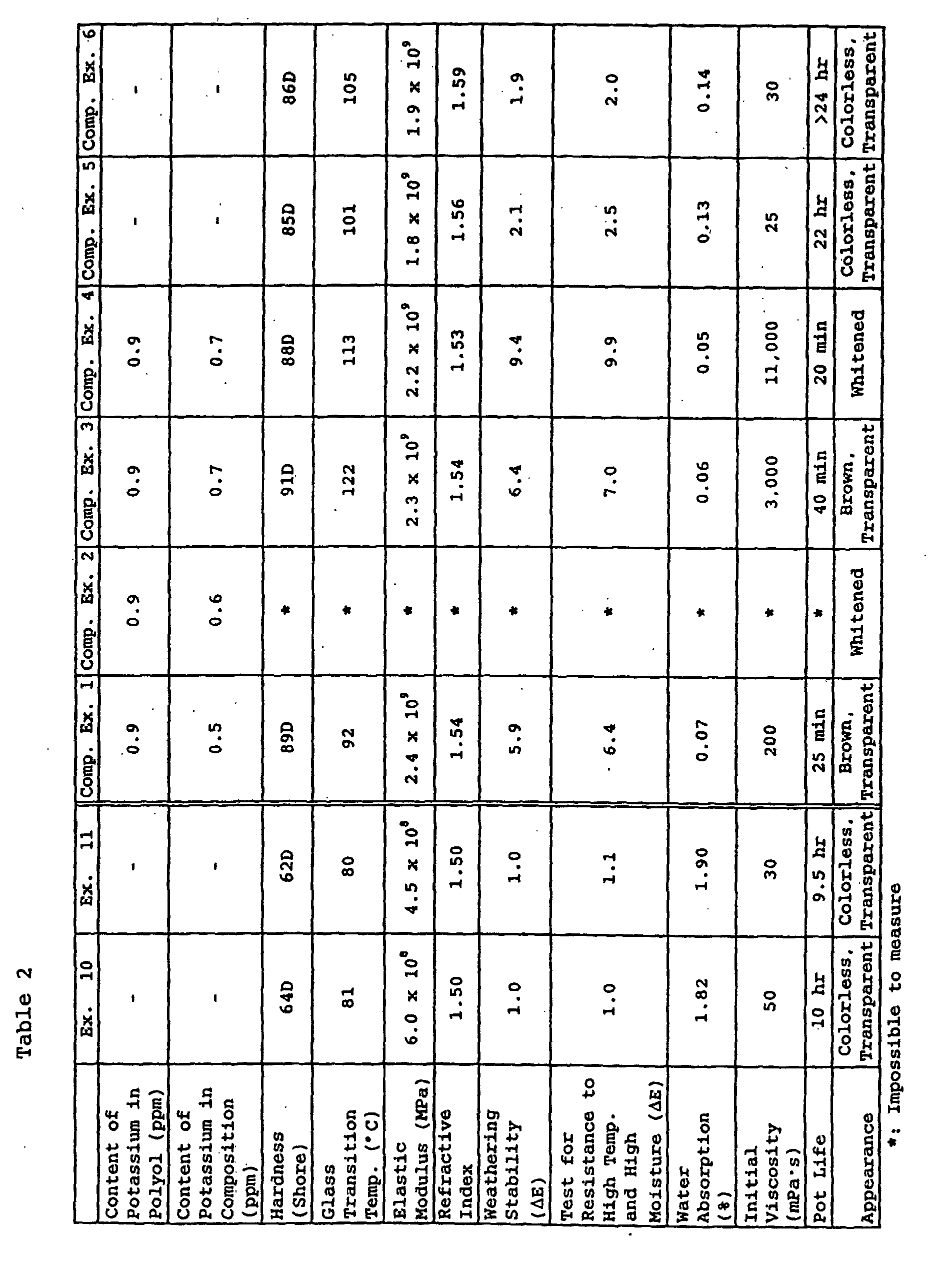

### Application Example 1

A light-emitting diode lamp was prepared by using the urethane prepolymer (A-1) and polyol used in Example 6. The urethane prepolymer (A-1) and the polyol were stirred and mixed for 10 minutes to be dissolved homogenously by the same method as in Examples. The resultant solution was subjected to deaeration under a reduced pressure of 2.6 kPa for 10 minutes and then poured into a mold having an internal diameter of 5 mm and a depth of 10 mm. Subsequently, in the urethane resin composition for an optoelectric conversion element sealer which had been poured into the mold, a GaAlAs-type light-emitting diode, which had been placed on a lead frame and wire-bonded, was immersed. Then, the mold was placed in an oven heated to 100°C and reaction was carried out for 3 hours, and the contents of the mold was then after-cured at 120°C for 5 hours, thereby obtaining a light-emitting diode lamp of the present invention.

### Application Comparative Example 1

A light-emitting diode lamp was prepared in accordance with the same procedure as in Application Example 1 by the use of the components (A) and (B) in Comparative Example 5.

The results of evaluation regarding the light-emitting diode lamps obtained in Application Example 1 and Application Comparative Example 1 are shown in Table 3.

**Table 3**

| | Application Example 1 | Application Comparative Example 1 |
|---|---|---|
| Appearance after Weathering Test | O | X |

### Industrial Applicability

A urethane resin composition for an optoelectric conversion element sealer according to the present invention comprises a component (A) containing a compound having isocyanate groups and a component (B) containing a compound having hydroxyl groups. Since the compound having isocyanate groups is at least one compound selected from the group consisting of an aromatic isocyanate having a structure in which the isocyanate groups are not directly bonded to the benzene ring, an aliphatic isocyanate, an alicyclic isocyanate, and derivatives of these isocyanates, the urethane resin composition is hardly colored and has excellent heat stability and weathering stability, high elastic modulus and good curing characteristics. It also has a long pot life and excellent workability.

Furthermore, the light-emitting diode lamp according to the present invention has the above characteristics as well as excellent workability at the time of sealing and excellent weathering stability, since the resin composition comprising the component (A) containing at least one compound selected from the group consisting of an aromatic isocyanate having a structure in which the isocyanate groups are not directly bonded to the benzene ring, an aliphatic isocyanate and an alicyclic isocyanate and the component (B) containing hydroxyl groups reacts and is cured to seal a light-emitting diode.

## Claims

1. A urethane resin for an optoelectric conversion element sealer, which has:
1) a refractive index of 1.45 or more as measured by using a D line from a helium light source,
2) a glass transition temperature (Tg) of 75°C or more, and
3) a ΔE of 1.5 or less as measured after irradiation for 600 hours by a sunshine weatherometer using a carbon arc lamp.

2. The resin according to claim 1, which has a ΔE of 1.5 or less after treated for 300 hours in a thermostatic chamber having a relative humidity of 90% and a temperature of 80°C.

3. The resin according to claim 1 or 2, wherein the content of sulfur atoms is 500 ppm or less.

4. The resin according to any one of claims 1 to 3, wherein the content of alkali metal atoms is 10 ppm or less.

5. A urethane resin composition for an optoelectric conversion element sealer comprising a component (A) containing a compound having at least two isocyanate groups and a component (B) containing a compound having hydroxyl groups, wherein the compound having isocyanate groups in the component (A) is at least one compound selected from the group consisting of:
(i) an aromatic polyisocyanate having a structure in which any isocyanate groups are not directly bonded to a benzene ring,
(ii) an aliphatic polyisocyanate,
(iii) an alicyclic polyisocyanate, and
(iv) derivatives of the polyisocyanates (i) to (iii).

6. The composition according to claim 5, wherein the compound having isocyanate groups is a modified isocyanurate or prepolymer of the polyisocyanates (i) to (iii).

7. The composition according to claim 5 or 6, wherein an initial mixing viscosity at the time of mixing the component (A) and the component (B) together at 20°C is in a range of 10 to 10,000 mPa·s.

8. The composition according to any one of claims 5 to 7, wherein a time required for a viscosity after mixing of the component (A) and the component (B) to become twice as much as the initial mixing viscosity is in a range of 2 to 20 hours.

9. The composition according to any one of claims 5 to 8, wherein the compound having isocyanate groups is a polycyclic alicyclic polyisocyanate or its modification.

10. The composition according to claim 9, wherein the polycyclic alicyclic polyisocyanate is a polycyclic alicyclic diisocyanate represented by the following general formula [I]: 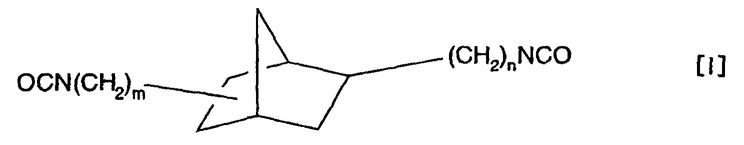 wherein m and n each independently represent an integer of 1 to 5.

11. The composition according to claim 10, wherein the polycyclic alicyclic polyisocyanate is a polycyclic alicyclic diisocyanate represented by the formula [I] wherein both m and n are 1.

12. The composition according to claim 5, wherein the compound having isocyanate groups is at least one compound selected from the group consisting of diisocyanatomethylbenzene, bis(1-isocyanato-1,1-dimethyl)benzene, 4,4'-diisocyanato-dicyclohexylmethane, 1-isocyanato-3,5,5-trimethyl-3-isocyanatomethylcyclohexane and bisisocyanatomethylcyclohexane.

13. The composition according to any one of claims 5 to 12, wherein the compound having hydroxyl groups is a compound having at least two hydroxyl groups.

14. The composition according to claim 12 or 13, wherein the content of alkali metal atoms in the compound having at least two hydroxyl groups is 10 ppm or less.

15. The composition according to any one of claims 5 to 14, which has a glass transition temperature of at least 75°C after cured.

16. The composition according to any one of claims 5 to 15, which has a refractive index of 1.45 to 1.80 as measured by using a D line from a helium light source after cured.

17. The composition according to claim 5 or 16, which has
a ΔE of 1.5 or less as measured after irradiation for 600 hours by a sunshine weatherometer using a carbon arc lamp after cured,
a ΔE of 1.5 or less after treated for 300 hours in a thermostatic chamber having a relative humidity of 90% and a temperature of 80°C,
a content of sulfur atoms of 500 ppm or less, and
a content of alkali metal atoms of 10 ppm or less.

18. An optoelectric conversion device obtained by curing a resin composition comprising a component (A) containing a compound having isocyanate groups and a component (B) containing a compound having hydroxyl groups to seal an optoelectric conversion element, wherein the compound having isocyanate groups in the component (A) is at least one compound selected from the group consisting of:
(i) an aromatic polyisocyanate having a structure in which any isocyanate groups are not directly bonded to a benzene ring,
(ii) an aliphatic polyisocyanate,
(iii) an alicyclic polyisocyanate, and
(iv) derivatives of the polyisocyanates (i) to (iii).

19. The device according to claim 18, wherein the optoelectric conversion element is a light-emitting or a light-receiving element.

20. The device according to claim 19, wherein the optoelectric conversion element is a light-emitting diode.

21. A method for producing a urethane resin for an optoelectric conversion element sealer which comprises heating a resin composition comprising a component (A) containing a compound having isocyanate groups and a component (B) containing a compound having hydroxyl groups to react and cure the composition, wherein the compound having isocyanate groups in the component (A) is at least one compound selected from the group consisting of:
(i) an aromatic polyisocyanate having a structure in which any isocyanate groups are not directly bonded to a benzene ring,
(ii) an aliphatic polyisocyanate,
(iii) an alicyclic polyisocyanate, and
(iv) derivatives of the polyisocyanates (i) to (iii).

22. A method for producing an optoelectric conversion device which comprises sealing an optoelectric conversion element with a resin composition comprising a component (A) containing a compound having isocyanate groups and a component (B) containing a compound having hydroxyl groups by heating the resin composition to react and cure the composition, wherein the compound having isocyanate groups in the component (A) is at least one compound selected from the group consisting of:
(i) an aromatic polyisocyanate having a structure in which any isocyanate groups are not directly bonded to a benzene ring,
(ii) an aliphatic polyisocyanate,
(iii) an alicyclic polyisocyanate, and
(iv) derivatives of the polyisocyanates (i) to (iii).

23. The method according to claim 22, wherein the optoelectric conversion element is a light-emitting or a light-receiving element.

24. The method according to claim 23, wherein the optoelectric conversion element is a light-emitting diode.
